(19) Europäisches Patentamt
European Patent Office
Office européen des brevets

(11) **EP 1 221 175 B1**

(12) **EUROPÄISCHE PATENTSCHRIFT**

(45) Veröffentlichungstag und Bekanntmachung des Hinweises auf die Patenterteilung:
**31.01.2007 Patentblatt 2007/05**

(21) Anmeldenummer: **00953372.0**

(22) Anmeldetag: **29.08.2000**

(51) Int Cl.:
*H01J 37/34* *(2006.01)*

(86) Internationale Anmeldenummer:
**PCT/IB2000/001195**

(87) Internationale Veröffentlichungsnummer:
**WO 2001/027970 (19.04.2001 Gazette 2001/16)**

(54) **ELEKTRISCHE VERSORGUNGSEINHEIT UND VERFAHREN ZUR REDUKTION DER FUNKENBILDUNG BEIM SPUTTERN**

ELECTRIC SUPPLY UNIT AND A METHOD FOR REDUCING SPARKING DURING SPUTTERING

UNITE D'ALIMENTATION ELECTRIQUE ET PROCEDE PERMETTANT DE REDUIRE LA FORMATION D'ETINCELLES LORS DE LA PULVERISATION

(84) Benannte Vertragsstaaten:
**AT BE CH CY DE DK ES FI FR GB GR IE IT LI LU MC NL PT SE**

(30) Priorität: **13.10.1999 DE 19949394**

(43) Veröffentlichungstag der Anmeldung:
**10.07.2002 Patentblatt 2002/28**

(73) Patentinhaber: **Oerlikon Deutschland Holding GmbH**
**80331 München (DE)**

(72) Erfinder:
• **KLOEPPEL, Andreas**
**D-63695 Glauburg (DE)**
• **DAUBE, Christoph**
**D-63755 Alzenau (DE)**
• **STOLLENWERK, Johannes**
**D-63571 Gelnhausen (DE)**
• **LINZ, Thomas**
**D-77815 Bühl (DE)**

(74) Vertreter: **Troesch Scheidegger Werner AG**
**Schwäntenmos 14**
**8126 Zumikon (CH)**

(56) Entgegenhaltungen:
**US-A- 5 192 894**      **US-A- 5 698 082**

• **PATENT ABSTRACTS OF JAPAN vol. 1997, no. 12, 25. Dezember 1997 (1997-12-25) & JP 09 217171 A (ANELVA CORP), 19. August 1997 (1997-08-19)**
• **PATENT ABSTRACTS OF JAPAN vol. 1998, no. 11, 30. September 1998 (1998-09-30) & JP 10 168558 A (ANELVA CORP), 23. Juni 1998 (1998-06-23)**
• **PATENT ABSTRACTS OF JAPAN vol. 005, no. 132 (C-068), 22. August 1981 (1981-08-22) & JP 56 065981 A (HITACHI LTD), 4. Juni 1981 (1981-06-04)**

**Beschreibung**

Die vorliegende Erfindung betrifft eine elektrische Versorgungseinheit nach dem Oberbegriff von Anspruch 1, eine Sputteranlage nach dem Wortlaut von Anspruch 11, ein Verfahren zur Reduktion der Funkenbildung beim Sputtern nach dem Oberbegriff von Anspruch 14 und ein Fertigungsverfahren nach Anspruch 24.

Die vorliegende Erfindung geht von nachfolgender Problematik aus. Die daraus erfindungsgemäss geschöpften Erkenntnisse lassen sich generell für HF-versorgte Sputterprozesse einsetzen.

Beim Magnetronsputtern von ITO-Schichten von Oxydtargets und Versorgung der Plasmaentladung, kombiniert mit HF- und DC-, wird sporadisch das Entstehen von Funken beobachtet. Dies ist weiter nicht erstaunlich, denn das Auftreten derartiger Funken (Arcs) ist beim DC-Sputtern elektrisch schlecht leitender Materialien, sei dies zum Sputterätzen oder zum Sputterbeschichten, bekannt. Zur Vermeidung der Entstehung von Arcs bei DC-Sputtern, welche sowohl beim Sputterätzen wie auch beim Sputterbeschichten die Werkstücke namhaft beschädigen können, sind verschiedene Vorgehen bekannt. Beispielsweise wird der DC-Versorgung eine HF-Versorgungskomponente überlagert oder durch Arbeitspunktstabilisierung im sogenannten Intramode gearbeitet, oder die DC-Versorgung wird gechoppert, indem intermittierend die Plasmaentladungsstrecke über einen relativ niederohmigen Strompfad, unter Abtrennung von der DC-Versorgung, in sich kurzgeschlossen wird.

Um so erstaunlicher war es somit, dass trotz der der DC-Versorgung überlagerter HF-Versorgung das erwähnte Arcing beobachtet wurde und ein einmal entstandener Funke auch dann weiterbrannte, wenn gemäss Erfahrungen aus der DC-versorgten Sputtertechnik die DC-Versorgungskomponente stillgesetzt wurde.

Aus der JP-A-09217171 ist eine elektrische Versorgung für die elektrische Speisung einer Plasmaentladung in einer Sputterkammer bekannt, mittels welcher die Plasmaentladung mit einem Hochfrequenz-Versorgungssignal gespiesen wird. Das Hochfrequenz-Versorgungssignal wird dabei während ersten Zeitspannen stillgesetzt, die wesentlich kürzer sind als zweite Zeitspannen, während das erwähnte Signal angelegt ist.

Aus der JP-A-56065981 ist es weiter bekannt, die Plasmaentladungsstrecke einer Sputterquelle mittels Hochfrequenz- und DC-Spannung zu betreiben.

Es ist Aufgabe der vorliegenden Erfindung, eine elektrische Versorgungseinheit erstgenannter Art vorzuschlagen, mittels welcher diesbezüglich vorteilhaftes Sputtern erreicht wird. Dies wird durch die Versorgungseinheit eingangs genannter Art erreicht, welche sich nach dem Kennzeichen von Anspruch 1 auszeichnet.

Demnach ist die Versorgungseinheit so ausgebildet, dass die HF-Versorgung der Sputterplasmaentladung kurzzeitig stillgesetzt wird und nebst dem erwähnten HF-Generator, ein DC-Generator vorgesehen ist, dessen Ausgangssignal demjenigen des HF-Generators überlagert ist.

Auch der DC-Generator weist eine gesteuerte Schalteinheit auf, mittels welcher das DC-Versorgungssignal kurzzeitig stillgesetzt wird.

In einer ersten bevorzugten Ausführungsform der erfindungsgemässen Versorgungseinheit weist die die Stillsetzung steuernde Schalteinheit einen Steuereingang auf, welcher mit dem Ausgang einer Funkendetektionseinheit wirkverbunden ist. Dadurch wird es möglich, unmittelbar beim Entstehen eines Funkens die Hochfrequenzversorgung der Plasmaentladung stillzusetzen.

In üblicher Art und Weise weist der für die Versorgung vorgesehene HF-Generator eine elektrische Versorgungseinheit auf, welche beispielsweise eingangsseitige Netzspannung in Versorgungsgleichspannung für den nachgeschalteten HF-Oszillator wandelt.

In einer bevorzugten Ausführungsform der erfindungsgemässen Einheit wird die für die erfindungsgemässe Stillsetzung der Hochfrequenzversorgung vorgesehene Schalteinheit dieser erwähnten, HF-Generator-internen Versorgungseinheit nachgeschaltet, d.h. zwischen dem Ausgang der erwähnten Versorgungseinheit und demjenigen des HF-Generators angeordnet. Dies kann nach der erwähnten Generator-Versorgungseinheit bis ausgangsseitig einer üblicherweise vorgesehenen und vorliegendenfalls als Teil des Generators betrachteten Impedanz-Anpasseinheit erfolgen.

In einer bevorzugten Ausführungsform der mit einer Funkendetektionseinheit ausgerüsteten erfindungsgemässen Versorgungseinheit umfasst letztere eine DC-Potentialmesseinheit, deren Ausgang mit dem Eingang einer vorzugsweise einstellbaren Schwellwert-Detektionseinheit wirkverbunden ist, deren Ausgang wiederum als Ausgang der Funkendetektionseinheit wirkt:

Auch bei HF-Versorgung einer Plasmaentladung entstehen bekanntlich entlang der Plasmaentladungsstrecke DC-Potentiale - DC-Potentialabfälle über den Elektroden-Dunkelräumen, im wesentlichen konstantes DC-Potential entlang der übrigen Plasmastrecke - deren Werte sich bei Entstehen eines niederohmigen Funkenpfades detektierbar ändern.

In einer weiteren bevorzugten Ausführungsform der erfindungsgemässen Versorgungseinheit beträgt die Stillsetzungszeit der HF-Versorgung höchstens 40 μsec., vorzugsweise gar höchstens 30 μsec.

Dadurch wird erreicht, dass einerseits ein im Entstehen begriffener Funke gelöscht wird bzw. wie noch auszuführen sein wird gar nicht erst entstehen kann und gleichzeitig eine stabile Entladung unmittelbar weiterbetrieben wird.

In einer weiteren bevorzugten Ausführungsform wird erreicht, insbesondere bei Vorsehen Funkendetektions-ausgelöster Stillsetzung der HF-Versorgung, dass nebst dem vorerwähnten raschen Wiederaufschalten, nach Funkenenstehungs-Detektion, die HF-Versorgung so rasch abgeschaltet wird, dass sich der im Entstehen begriffene Funke gar nicht erst voll ausbilden kann. Dies wird dadurch erreicht, dass die Zeitspanne zwischen Funkendetektion und Abschalten der Hochfrequenzversorgung höchstens 50 μsec. beträgt, vorzugsweise höchstens 30 μsec.

In einer weiteren bevorzugten Ausführungsform wird die erfindungsgemäss vorgesehene Schalteinheit in der Art einer monostabilen Einheit ausgebildet. Ausgelöst durch ein Detektionssignal am Ausgang der vorgesehenen Funkendetektionseinheit wird dadurch die Hochfrequenzversorgung für die bevorzugterweise einstellbare Zeitspanne stillgesetzt, dann wieder aufgeschaltet. Liegen dann, erfasst durch die Funkendetektionseinheit, weiterhin funkenanzeigende Messwerte vor, so wird die HF-Versorgung wieder stillgesetzt: Es entsteht, funkendetektiongesteuert, ein repetitives Ein- und Abschalten der erwähnten Versorgung, solange, bis die Funkendetektionseinheit keine Versorgungsabschaltung mehr auslöst. Dabei bleibt aber die Versorgungsabschaltung abhängig von der Detektion eines mindestens im Entstehen begriffenen Funkens.

In einer weiteren bevorzugten Ausführungsform wird dies aber dadurch umgangen, dass, freilaufend, die HF-Versorgung repetitiv kurzzeitig stillgesetzt wird.

Ist für die Auslösung bzw. Stillsetzung der HF-Versorgung eine Funkendetektionseinheit vorgesehen, so kann letztere auch die Stillsetzung der DC-Versorgung ansteuern. Selbstverständlich kann dies direkt erfolgen oder aber, indem in gegenseitiger zeitlicher Abhängigkeit, wie noch zu erläutern sein wird, HF- und DC-Versorgung stillgesetzt bzw. aufgeschaltet werden.

Bevorzugterweise erfolgt an der erfindungsgemässen Versorgungseinheit die voneinander abhängige zeitliche Ansteuerung der vorgesehenen gesteuerten Schalteinheiten so, dass die DC-Versorgung vor der HF-Versorgung stillgesetzt wird. Die HF-Versorgung wird vor oder nach der DC-Versorgung wieder aufgeschaltet, bevorzugt nachher.

Die erfindungsgemässe Versorgungseinheit wird in einer bevorzugten Ausführungsform realisiert unter Verwendung einer DC-Versorgung des Typs "Pinnacle" von der Firma Advanced Energy.

Bevorzugte Ausführungsformen der erfindungsgemässen Sputteranlage sind in den Ansprüchen 12 und 13 spezifiziert, bevorzugte Ausführungsformen des erfindungsgemässen Verfahrens in den Ansprüchen 15 - 23.

Im weiteren bezieht sich die vorliegende Erfindung auf ein Fertigungsverfahren nach dem Wortlaut von Anspruch 24, mittels welchem die resultierenden gesputterten - sputtergeätzten oder sputterbeschichteten - Bauteile aufgrund mindestens stark reduzierter Funkeneinflussnahme mit erhöhter Qualität bzw. mit wesentlich verringertem Ausschuss produziert werden können.

Die Erfindung wird anschliessend beispielsweise anhand von Figuren erläutert. Es zeigen:

Fig. 1   In Form eines Funktionsblock/Signalflussdiagrammes eine Versorgungseinheit mit freilaufender Funkenverhinderung;

Fig. 2   in Darstellung analog zu Fig. 1, eine erfindungsgemässe Weiterausbildung mit DC- und HF-Versorgung;

Fig. 3   ausgehend von der in Fig. 1 dargestellten Technik, eine Ausführungsform mit Funkenentstehungs-gesteuerter Versorgungs-Stillsetzung;

Fig. 4   ausgehend von der Technik nach Fig. 2, eine Ausführungsform für Funkenentstehungs-ausgelöste Versorgungsunterbrechung, und

Fig. 5   eine weitere Ausführungsform der anhand von Fig. 4 erläuterten Technik.

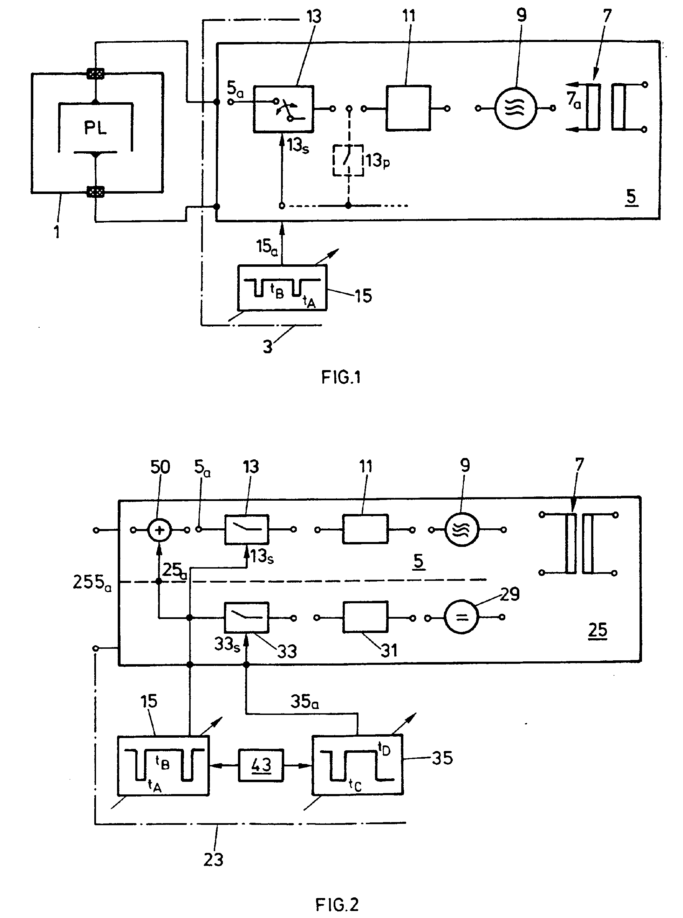

In Fig. 1 ist schematisch, anhand eines vereinfachten Funktionsblock/Signalflussdiagrammes, eine Ausführungsform einer Versorgungseinheit, aufgeschaltet an eine Sputterkammer, dargestellt.

Bei einer Sputterkammer 1 kann es sich um eine Sputterbeschichtungskammer oder eine Sputterätzkammer handeln, dabei, wie dargestellt, um eine Dioden-Sputterkammer oder (nicht dargestellt) um eine Trioden- oder gar Mehrelektroden-Sputterkammer.

Jedenfalls und wie hinlänglichst bekannt, ist in der Sputterkammer 1 eine Plasmaentladungsstrecke PL zwischen mindestens zwei Elektroden vorgesehen.

Für die vorliegende Erfindung ist Typ und Aufbau der Sputterkammer 1 sekundär, wesentlich ist, dass ein Teil der Plasmaentladungsversorgung mittels HF-Energie erfolgt. Gemäss Fig. 1 ist eine Versorgungseinheit 3 vorgesehen. Diese umfasst einen HF-Generator 5 mit einer Stromversorgungseinheit 7, einer HF-Oszillatoreinheit 9, einer aktiven oder passiven, gegebenenfalls einstellbaren Anpasseinheit 11 (Matchbox). Zwischen dem Ausgang $7_a$ der Stromversorgungseinheit 7 und dem Ausgang $5_a$ des Generators 5, welcher mit der Plasmaentladungsstrecke PL verbunden wird, ist eine gesteuerte Schalteinheit 13 vorgesehen, beispielsweise, gemäss der Darstellung von Fig. 1, unmittelbar dem Ausgang $5_a$ vorgeschaltet. Die Schalteinheit 13 weist einen Steuereingang $13_s$ auf, welcher mit dem Ausgang $15_a$ eines frei schwingenden Taktgebers 15 verbunden ist. Mit dem frei schwingenden Taktgeber 15 wird die Schalteinheit 13 während ersten Zeitspannen $t_A$ so geschaltet, dass am Ausgang $5_a$ die HF-Versorgung abgeschaltet ist und während zweiten Zeitspannen $t_B$ aufgeschaltet. Bezüglich der Taktverhältnisse wird angeraten:

- Duty cycle:

$$(t_B/(t_B + t_A)) \geq 0,9$$

**-** Stillsetzzeiten:

$$t_A \leq 100 \ \mu sec.$$

Die gesteuerte Schalteinheit 13 kann dabei als Seriechopper (wie dargestellt) ausgebildet sein oder als Parallelchopper, wie bei $13_p$ gestrichelt angedeutet.

Fig. 2 zeigt eine erfindungsgemässe Weiterbildung der bereits in Fig. 1 grundsätzlich dargestellten, frei schwingenden Ausführungsform u.a. der Versorgungseinheit.

Es sind für Funktionsblöcke und Signale, welche bereits anhand von Fig. 1 beschrieben wurden, weiterhin dieselben Referenzen verwendet.

Gemäss Fig. 2 umfasst die erfindungsgemässe Versorgungseinheit 23 nebst dem HF-Generator 5 einen DC-Generator 25. HF-Generator 5 und DC-Generator 25 können dabei von derselben Versorgungseinheit 7 wie dargestellt versorgt werden.

Der DC-Generator 25 umfasst eine DC-Spannungserzeugungsstufe 29, ihr nachgeschaltet üblicherweise eine Tiefpassfiltereinheit 31 und eine gesteuerte Schalteinheit 33. Der Ausgang $25_a$ des DC-Generators und derjenige $5_a$ des HF-Generators 5 sind an einer Überlagerungsstufe 50 überlagert, welche auch gebildet sein kann durch eine gemeinsam beschaltete Elektrode der Plasmaentladungsstrecke PL gemäss Fig. 1.

Wie der Steuereingang $13_s$ der Schalteinheit 13 wirkverbunden ist mit dem Taktgeber 15, ist ein Steuereingang $33_s$ der Schalteinheit 33 mit einem Taktgeber 35 wirkverbunden. Damit wird das DC-Versorgungssignal am Ausgang $255_a$ der Versorgungseinheit 23 bzw. am DC-Ausgang $25_a$ auf- und abgeschaltet: Während dritten Zeitspannen $t_C$ wird die DC-Versorgung durch den Taktgeber 35 stillgesetzt, während vierten $t_D$ aufgeschaltet. Die beiden Taktgeber 15 und 35, welche durchaus gemeinsam realisiert sein können, werden grundsätzlich wie mit der Synchronisierungseinheit 43 dargestellt in gegenseitiger zeitlicher Abhängigkeit betrieben.

In einer bevorzugten Ausführungsform gilt bezüglich der Zeitverhältnisse $t_A$ bis $t_D$ folgendes:

**-** Die Zeitabschnitte $t_C$ beginnen vor den Zeitabschnitten $t_A$, d.h. die DC-Versorgung wird vor der HF-Versorgung abgeschaltet.

**-** Bevorzugterweise wird weiter der jeweilige Zeitabschnitt $t_C$ beendet, bevor $t_A$ beendet ist, d.h. die DC-Versorgung wird aufgeschaltet, bevor die HF-Versorgung wieder aufgeschaltet wird.

Es gelten bevorzugt folgende Zeitverhältnisse:

$$0,25 \leq t_C/t_A \leq 0,5$$

Grundsätzlich sind weiter die Aufschaltzeitspannen $t_B$ und $t_D$ wesentlich länger als die Abschaltzeitspannen $t_A$ bzw. $t_C$.

Aufgrund der Darstellungen von Fig. 1 und 2 eröffnen sich dem Fachmann viele Varianten, die erfindungsgemässe Versorgungseinheit so zu realisieren, dass primär die HF-Versorgung intermittierend kurzzeitig stillgesetzt wird und zusätzlich eine DC-Versorgung vorgesehen ist, die mit der HF-Versorgungs-Stillsetzung synchronisiert, stillgesetzt wird.

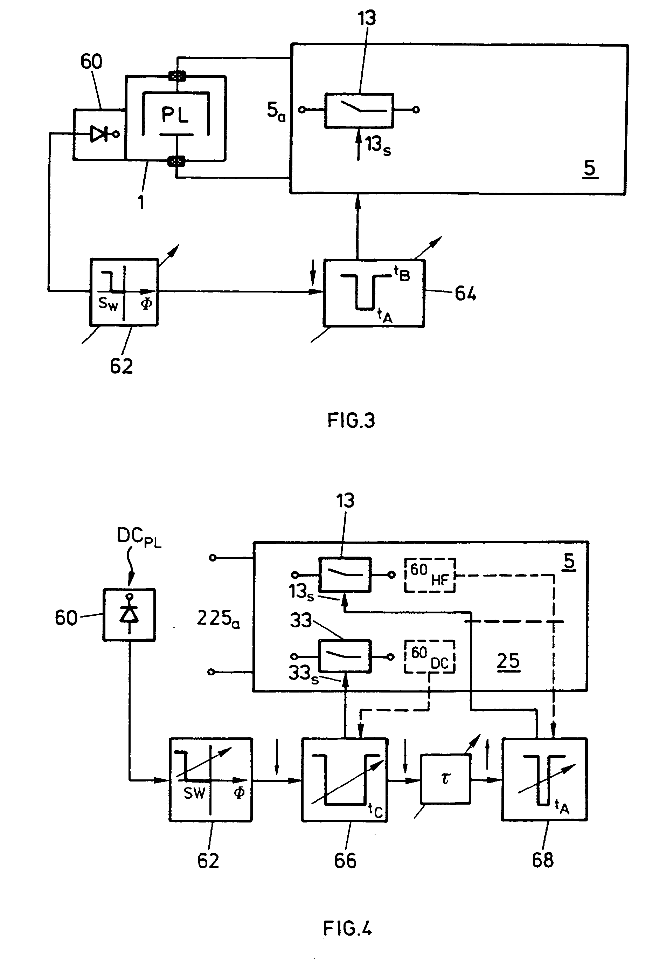

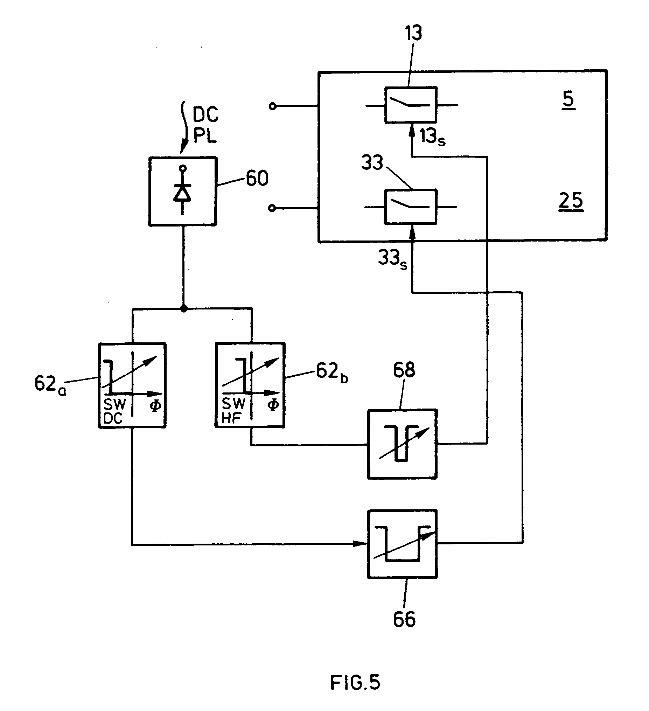

In den Fig. 3 und 4, ist in Analogie zu den Fig. 1 und 2, jeweils eine weitere bevorzugte Ausführungsform der erfindungsgemässen Versorgungseinheit dargestellt, bei der die Versorgungsunterbrechungen HF- und DC-mässig nicht frei schwingend erfolgen, sondern ausgelöst durch Detektion einer Funkenentstehung in der Sputterkammer.

Bezüglich den Fig. 3 und 4 werden lediglich die Unterschiede mit Bezug auf die Fig. 1 und 2 beschrieben.

Gemäss Fig. 3 ist an der erfindungsgemässen Versorgungseinheit eine Funkendetektionseinheit 60 vorgesehen. In einer bevorzugten Ausführungsform erfasst diese ein Plasmaentladungsbedingtes DC-Potential. An einer vorzugsweise einstellbaren Schwellwerteinheit 62 wird ermittelt, ob dieses überwachte DC-Potential $\phi$, beispielsweise das Plasmapotential, den eingestellten Schwellwert SW erreicht, woraus auf das Entstehen eines Funkens geschlossen wird. Ausgangsseitig triggert die Schwellwerteinheit 62 eine Zeitsteuereinheit 64, welche in der Art eines monostabilen Multivibrators ein Stillsetzungs-Steuersignal der vorzugsweise einstellbaren Länge $t_A$ an die gesteuerte Schalteinheit 13 abgibt. Somit wird die HF-Versorgung dann kurzzeitig, $t_A$, stillgesetzt, wenn das Entstehen eines Funkens in der Plasmaentladung PL detektiert wird, beispielsweise das Plasmapotential bedingt durch den niederohmigen Funkenschluss absinkt.

Wird daraufhin, durch die Zeitsteuereinheit 64, die HF-Versorgung wieder aufgeschaltet ($t_B$), so setzt sich die stabile Plasmaentladung PL fort, sofern nicht über die Detektionseinheit 60 weiterhin oder wieder das Entstehen eines Funkens detektiert wird. Ist letzteres der Fall, so wird über die Einheiten 62, 64 die HF-Versorgung wiederum stillgesetzt. Es entsteht solange ein repetitives Abschalten der HF-Versorgung, bis keine Funken mehr detektiert werden.

Die Detektionseinheit 60, in Fig. 3 schematisch an die Sputterkammer 1 bzw. deren Plasmaentladung PL angekoppelt dargestellt, kann selbstverständlich auch und wird auch bevorzugterweise, zur Erfassung der elektrischen Entladungs-Verhältnisse, direkt mit den Speiseleitungen zu den Entladungselektroden wirkverbunden.

In Fig. 4 ist ausgehend von Fig. 2 die entsprechende Funkenentstehungs-gesteuerte Versorgungseinheit schematisch dargestellt für die kombinierte HF- und DC-Versorgung.

Gemäss Fig. 4 wird bei Detektion mindestens der Entstehung eines Funkens über die Detektionseinheit 60 und die Schwellwerteinheit 62 bevorzugterweise erst die Zeitsteuereinheit 66, in Art einer monostabilen Einheit, zur Stillsetzung der DC-Versorgung gemäss der Stillsetzungs-Zeitspanne $t_C$ angesteuert. In Abhängigkeit von letzterer wird, bevorzugterweise um eine einstellbare Zeitspanne $\tau$ verschoben, über die Zeitsteuereinheit 68 die HF-Versorgung stillgesetzt. Innerhalb der DC-Stillsetzungsphase $t_C$ ist es durchaus möglich, wiederholt die HF-Versorgung ein- und, bei weiterer Detektion eines Funkens, wieder stillzusetzen.

In Fig. 5 ist ausgehend von Fig. 4 eine weitere Ausführungsform dargestellt, gemäss welcher, Schwellwert-empfindlich, DC- und HF-Versorgung stillgesetzt werden.

Gemäss dieser Fig. wird ausgangsseitig der Detektionseinheit 60 auf Erreichen eines ersten Schwellwertes SW-DC an der Schwellwerteinheit 62a geprüft und eines zweiten Schwellwertes SW-HF an der Schwellwerteinheit 62b. Bei Erreichen des Schwellwertes SW-DC wird über die Zeitsteuereinheit 66 die DC-Versorgung stillgesetzt, bei Erreichen des Schwellwertes SW-HF über die Einheit 68 die HF-Versorgung.

Selbstverständlich eröffnen sich nun dem Fachmann verschiedenste Möglichkeiten, bei DC- und HF-Versorgung Kombinationen von Zeitsteuerung und Schwellwertsteuerung vorzusehen und optimal zeitgestaffelt DC- und HF-Versorgung jeweils kurzzeitig stillzusetzen.

In einer bevorzugten Ausführungsform werden Funkendetektionseinheit 60, Schwellwerteinheit 62, Zeitvorgabeeinheit 66 mit dem DC-Generator 25 bei der Ausführungsform gemäss Fig. 4 oder 5 unter Einsatz einer DC-Speisung des Typs "Pinnacle" der Firma Advanced Energy realisiert.

Berücksichtigt man, dass üblicherweise DC-Signale vom Eingang des HF-Oszillators entkoppelt werden und dass, umgekehrt, HF-Signale vom Eingang des DC-Generators getrennt werden, so ist ersichtlich, dass in bevorzugter Ausführungsform eine HF-Funkendetektionseinheit dem HF-Oszillator nachgeschaltet wird und eine DC-Funkendetektionseinheit dem DC-Generator. In Fig. 4 ist dies gestrichelt bei $60_{DC}$ und $60_{HF}$ dargestellt. Diese wirken je auf ihre zugeordneten Zeitvorgabeeinheiten 66 (DC) bzw. 68 (HF) .

Bei der Ausführungsform gemäss den Fig. 3 bis 5 wird vorzugsweise ab Detektion, d.h. Erreichen des entsprechenden Schwellwertes bei Entstehen eines Funkens, bis zur Stillsetzung der HF-Versorgung eine Zeitspanne T von $\leq 50$ $\mu$sec. eingestellt.

In einer bevorzugten Ausführungsform wird die erfindungsgemässe Versorgungseinheit mit einer Sputterbeschichtungskammer kombiniert, insbesondere bevorzugt mit einer Magnetronsputterkammer. Dabei eignet sich die erwähnte Versorgung besonders für das Sputtern schlecht leitender Materialien, insbesondere von Metalloxyden, dabei insbesondere von ITO, bevorzugt durch Magnetronsputtern.

Beim Magnetronsputtern von ITO-Targets mit einer HF-Leistungsdichte $P_{HF}$ von 0.75 W/cm$^2$ und einer DC-Versorgungs-Leistungsdichte $P_{DC}$ von 0.75 W/cm$^2$ an einer Anlage prinzipiell aufgebaut gemäss Fig. 4 erfolgt, ab Detektion der Funkenentstehung, die Versorgungsabschaltung (HF und DC) bereits nach 500 $\mu$sec. Bei erhöhter DC-Leistungsdichte von 1.5 W/cm$^2$ betrug diese Zeitspanne weiterhin weniger als 1 $\mu$sec.

Durch die erfindungsgemässe Versorgungseinheit, die erfindungsgemässe Sputteranlage bzw. das erfindungsgemässe Verfahren wird es möglich, auch HF/DC-Sputterprozesse, auch bei Neigung zur Funkenbildung kontrolliert zu betreiben. Durch die Möglichkeit, das Funkenereignis auf weniger als 1 $\mu$sec. zu begrenzen, wird ein stabiler Prozessbetrieb ermöglicht. Mit dem erfindungsgemässen Fertigungsprozess wird die Qualität von Oberflächen bei Sputterätzen oder Sputterbeschichten genannter Art wesentlich erhöht und damit der Werkstückausschuss verringert. Schäden durch Funkenbildung an Target, Werkstücken bzw. an Kammerwandpartien werden weitestgehend vermieden.

## Patentansprüche

1. Elektrische Versorgungseinheit für die elektrische Speisung einer Plasmaentladung (PL) in einer Sputterkammer (1), umfassend:

   mindestens einen HF-Generator (5),

   wobei

   der HF-Generator (5) eine gesteuerte Schalteinheit (13) umfasst, mittels welcher ein am Ausgang (5a) des HF-Generators (5) erzeugtes HF-Versorgungssignal während mindestens einer ersten Zeitspanne ($t_A$) stillgesetzt wird, die wesentlich kürzer ist als eine zweite ($t_B$) Zeitspanne, während welcher das HF-Versorgungssignal an besagtem Ausgang vorliegt, **dadurch gekennzeichnet, dass**

   zusätzlich ein DC-Generator (25) vorgesehen ist, dessen Ausgangssignal demjenigen des HF-Generators (5) überlagert ist, und dass der DC-Generator (25) eine weitere gesteuerte Schalteinheit (33) umfasst, mittels welcher ein am Ausgang des DC-Generators (25) erzeugtes DC-Versorgungssignal während mindestens einer dritten Zeitspanne ($t_C$) stillgesetzt wird, die wesentlich kürzer ist als eine vierte Zeitspannen ($t_D$) ist, während welcher das DC-Versorgungssignal an besagtem Ausgang anliegt

2. Elektrische Versorgungseinheit nach Anspruch 1, **dadurch gekennzeichnet, dass** die gesteuerte Schalteinheit (13) einen Steuereingang ($13_s$) aufweist, der mit dem Ausgang einer Funkendetektionseinheit (60) wirkverbunden ist.

3. Versorgungseinheit nach einem der Ansprüche 1 oder 2, **dadurch gekennzeichnet, dass** der HF-Generator (5) eine elektrische Versorgungseinheit (7) aufweist, deren Ausgang (7a) mit einem HF-Oszillator (9) wirkverbunden ist, wobei die gesteuerte Schalteinheit (13) zwischen dem Ausgang (7a) der Versorgungseinheit (7) des HF-Generators (5) und dem Ausgang (5a) des Generators (5) vorgesehen ist.

4. Versorgungseinheit nach einem der Ansprüche 2 oder 3, **dadurch gekennzeichnet, dass** die Funkendetektionseinheit (60) eine DC-Potential-Messeinheit umfasst, deren Ausgang mit dem Eingang einer vorzugsweise einstellbaren Schwellwert-Detektionseinheit (62) wirkverbunden ist, deren Ausgang mit dem Steuereingang ($13_s$) wirkverbunden ist.

5. Versorgungseinheit nach einem der Ansprüche 1 bis 4, **dadurch gekennzeichnet, dass** die erste Zeitspanne ($t_A$) höchstens 40 $\mu$sec., vorzugsweise höchstens 30 $\mu$sec. beträgt.

6. Versorgungseinheit nach einem der Ansprüche 2 bis 5, **dadurch gekennzeichnet, dass** eine Zeitspanne ab Auftreten eines die Funkendetektionseinheit (60) auslösenden Signals bis Auslösen der ersten Zeitspanne ($t_A$) höchstens 50 $\mu$sec., vorzugsweise höchstens 30 $\mu$sec. beträgt.

7. Versorgungseinheit nach einem der Ansprüche 2 bis 6, **dadurch gekennzeichnet, dass** die gesteuerte Schalteinheit in der Art einer monostabilen Einheit ausgebildet ist, welche das HF-Versorgungssignal, durch ein Detektionssignal am Ausgang der Funkendetektionseinheit (60) ausgelöst, für eine vorzugsweise einstellbare Zeitspanne ($t_A$) stillsetzt.

8. Versorgungseinheit nach einem der Ansprüche 1 bis 6, **dadurch gekennzeichnet, dass** der Steuereingang der gesteuerten Schalteinheit mit einer freilaufenden Takteinheit (15) wirkverbunden ist, die das HF-Versorgungssignal während der ersten Zeitspannen ($t_A$) repetitiv stillsetzt.

9. Versorgungseinheit nach Anspruch 2, **dadurch gekennzeichnet, dass** der Steuereingang ($33_s$) der weiteren Schalteinheit (33) des DC-Generators (25) mit dem Ausgang der Funkendetektionseinheit (60) wirkverbunden ist.

10. Versorgungseinheit nach Anspruch 9, **dadurch gekennzeichnet, dass** der Steuereingang ($13_s$) der gesteuerten Schalteinheit (13) des HF-Generators (5) und der Steuereingang ($33_s$) der weiteren gesteuerten Schalteinheit (33) des DC-Generators (25) über eine Zeitgebereinheit (15, 43, 35) so wirkverbunden sind, dass die dritte Zeitspanne ($t_C$) vor der ersten ($t_A$) beginnt und vor oder nach, bevorzugt vor der ersten ($t_A$) endet.

11. Sputteranlage mit einer Vakuumkammer (1) und einer Plasmaentladungsstrecke (PL), **dadurch gekennzeichnet, dass** die Plasmaentladungsstrecke (PL) an eine Versorgungseinheit (3) für elektrische Speisung der Plasmaentladungsstrecke nach einem der Ansprüche 1 bis 10 angeschlossen ist.

12. Sputteranlage nach Anspruch 11, **dadurch gekennzeichnet, dass** sie als Sputterbeschichtungsanlage ausgebildet ist und die eine Plasmaentladungselektrode ein Metalloxydtarget umfasst, vorzugsweise ein ITO-Target.

13. Sputteranlage nach Anspruch 11 oder 12, **dadurch gekennzeichnet, dass** die eine Plasmaentladungelektrode eine Magnetronelektrode ist.

14. Verfahren zur Reduktion der Funkenbildung beim Sputtern, bei dem die Plasmaentladung (PL) mittels HF-Energie mindestens mitversorgt wird, wobei man die HF-Versorgung der Plasmaentladung kurzzeitig ($t_A$) unterbricht, **dadurch gekennzeichnet, dass** man die Plasmaentladung zusätzlich mittels einer DC-Versorgung (25) speist, und auch die DC-Versorgung kurzzeitig stillsetzt.

15. Verfahren nach Anspruch 14, **dadurch gekennzeichnet, dass** man die DC-Versorgung vor der HF-Versorgung stillsetzt

16. Verfahren nach einem der Ansprüche 14 oder 15, **dadurch gekennzeichnet, dass** man aufgrund der Detektion (60) einer Funkenentstehung in der Kammer (1) die HF-Versorgung kurzzeitig ($t_A$) stillsetzt.

17. Verfahren nach einem der Ansprüche 14 bis 16, **dadurch gekennzeichnet, dass** man die HF-Versorgung ohne Stillsetzung der elektrischen Versorgung (7) eines HF-Generators (5) zur Erzeugung der HF-Versorgung stillsetzt.

18. Verfahren nach einem der Ansprüche 16 oder 17, **dadurch gekennzeichnet, dass** man die Funkenentstehung durch Messung eines DC-Potentials an der Plasmaentladung detektiert.

19. Verfahren nach einem der Ansprüche 14 bis 18, **dadurch gekennzeichnet, dass** man die HF-Versorgung während höchstens 40 $\mu$sec., vorzugsweise während höchstens 30 $\mu$sec. stillsetzt.

20. Verfahren nach einem der Ansprüche 16 bis 19, **da-**

**durch gekennzeichnet; dass** man ab Detektion der Funkenentstehung, die HF-Versorgung nach höchstens 50 μsec., vorzugsweise nach höchstens 30 μsec., stillsetzt.

21. Verfahren nach einem der Ansprüche 14 bis 20, **dadurch gekennzeichnet, dass** man die HF-Versorgung repetitiv stillsetzt, vorzugsweise periodisch.

22. Verfahren nach Anspruch 14, **dadurch gekennzeichnet, dass** man die DC-Versorgung aufgrund einer Detektion der Entstehung eines Funkens stillsetzt.

23. Verfahren nach Anspruch 14, **dadurch gekennzeichnet, dass** man die DC-Versorgung vor oder nach der Hochfrequenzversorgung wieder erstellt, vorzugsweise vor.

24. Verfahren zur Fertigung von Bauteilen mit einem Sputterverfahren, bei welchem die Versorgung der Sputterplasmaentladung eine HF-Komponente aufweist, und bei dem man die HF-Versorgungskomponente kurzzeitig stillsetzt, **dadurch gekennzeichnet, dass** man die Plasmaentladung zusätzlich mittels einer DC-Versorgung (25) speist und die DC-Versorgung kurzzeitig stillsetzt.

**Claims**

1. Electrical supply unit for the electrical supply of a plasma discharge (PL) in a sputter chamber (1), comprising at least one HF generator (5), wherein the HF generator (5) comprises a controlled switch unit (13) by means of which an HF supply signal generated at the output (5a) of the HF generator (5) is shut down for at least a first time period ($t_A$) that is substantially shorter than a second time period ($t_B$) during which the HF supply signal is present at said output, **characterised in that** in addition a DC generator (25) is provided, the output signal of which is superimposed on the output signal of the HF generator (5), and that the DC generator (25) comprises a further controlled switch unit (33) by means of which a DC supply signal generated at the output of the DC generator (25) is shut down during at least a third time period ($t_C$) that is substantially shorter than a fourth time period (to) during which the DC supply signal is present at said output.

2. Electrical supply unit according to claim 1, **characterised in that** the controlled switch unit (13) has a control input ($13_s$) that is operationally connected to the output of a spark detection unit (60).

3. Supply unit according to one of claims 1 or 2, **characterised in that** the HF generator (5) has an electrical supply unit (7), the output (7a) of which is operationally connected to an HF oscillator (9), wherein the controlled switch unit (13) is provided between the output (7a) of the supply unit (7) of the HF generator (5) and the output (5a) of the generator (5).

4. Supply unit according to one of claims 2 or 3, **characterised in that** the spark detection unit (60) comprises a DC potential measuring unit, the output of which is operationally connected to the input of a preferably adjustable threshold value detection unit (62), the output of which is operationally connected to the control input ($13_s$).

5. Supply unit according to any of claims 1 to 4, **characterised in that** the first time interval ($t_A$) amounts to maximum 40 μsec, preferably maximum 30 μsec.

6. Supply unit according to any of claims 2 to 5, **characterised in that** a time interval from the occurrence of a signal triggering the spark detection unit (60) until triggering of the first time interval ($t_A$) amounts to maximum 50 μsec, preferably maximum 30 μsec.

7. Supply unit according to any of claims 2 to 6, **characterised in that** the controlled switch unit is embodied in the manner of a monostable unit which shuts down the HF supply signal for a preferably adjustable time interval ($t_A$) when triggered by a detection signal at the output of the spark detection unit (60).

8. Supply unit according to any of claims 1 to 6, **characterised in that** the control input of the controlled switch unit is operationally connected to a free-running clock unit (15) which repetitively shuts down the HF supply signal during the first time interval ($t_A$).

9. Supply unit according to claim 2, **characterised in that** the control input ($33_s$) of the further switch unit (33) of the DC generator (25) is operationally connected to the output of the spark detection unit (60).

10. Supply unit according to claim 9, **characterised in that** the control input ($13_s$) of the controlled switch unit (13) of the HF generator (5) and the control input ($33_s$) of the further controlled switch unit (33) of the DC generator (25) are in such a way operationally connected via a timer unit (15, 43, 35), that the third time interval ($t_C$) begins before the first ($t_A$) and ends before or after, preferably before, the first ($t_A$).

11. Sputter plant with a vacuum chamber (1) and a plasma discharge section (PL), **characterised in that** the plasma discharge section (PL) is connected to a supply unit (3) for electrical supply of the plasma discharge section according to any of claims 1 to 10.

**12.** Sputter plant according to claim 11, **characterised in that** it is embodied as a sputter coating plant and the one plasma discharge electrode comprises a metal oxide target, preferably an ITO target.

**13.** Sputter system according to claim 11 or 12, **characterised in that** the one plasma discharge electrode is a magnetron electrode.

**14.** Method for reducing spark formation on sputtering, in which the plasma discharge (PL) is at least co-supplied by means of HF energy, wherein the HF supply to the plasma discharge is interrupted for a short period ($t_A$), **characterised in that** the plasma discharge is also fed by means of a DC supply (25) and the DC supply is also shut down for a short period.

**15.** Method according to claim 14, **characterised in that** the DC supply is shut down before the HF supply.

**16.** Method according to one of claims 14 or 15, **characterised in that** the I-IF supply is shut down for a short period ($t_A$) upon the detection (60) of a spark generation in the chamber (1).

**17.** Method according to any of claims 14 to 16, **characterised in that** the HF supply is shut down without shutting down the electrical supply (7) of an HF generator (5) for generating the HF supply.

**18.** Method according to one of claims 16 or 17, **characterised in that** the spark generation is detected by measuring a DC potential at the plasma discharge.

**19.** Method according to any of claims 14 to 18, **characterised in that** the HF supply is shut down for maximum of 40 $\mu$sec, preferably a maximum of 30 $\mu$sec.

**20.** Method according to any of claims 16 to 19, **characterised in that** from detection of the spark generation, the HF supply is shut down after maximum 50 $\mu$sec, preferably maximum 30 $\mu$sec.

**21.** Method according to any of claims 14 to 20, **characterised in that** the HF supply is shut down repetitively, preferably periodically.

**22.** Method according to claim 14, **characterised in that** the DC supply is shut down upon a detection of a generation of a spark.

**23.** Method according to claim 14, **characterised in that** the DC supply is restored before or after the high frequency supply, preferably before.

**24.** Method for production of components in a sputter process in which the supply to the sputter plasma discharge has an HF component, and wherein the HF supply component is shut down for a short period, **characterised in that** the plasma discharge is, in addition, supplied by means of a DC supply (25) and that the DC supply is shut down for a short period.

**Revendications**

**1.** Unité d'alimentation électrique pour l'alimentation électrique d'une décharge de plasma (PL) dans une chambre de pulvérisation cathodique (1), comprenant :

au moins une génératrice HF (5), la génératrice (5) comprenant elle-même une unité de commutation commandée (13) à l' aide de laquelle un signal d'alimentation HF généré à la sortie (5a) de la génératrice HF (5) est arrêté pendant au moins une première période ($t_A$) qui est nettement plus courte qu'une deuxième période ($t_B$) pendant laquelle le signal d'alimentation HF est appliqué à ladite sortie,

**caractérisée en ce qu'**il est prévu en plus une génératrice à courant continu (25) dont le signal de sortie s'ajoute à celui de la génératrice HF (5), et **en ce que** la génératrice à courant continu (25) comprend une autre unité de commutation commandée (33) grâce à laquelle un signal d'alimentation en courant continu produit à la sortie de la génératrice à courant continu (25) est arrêté pendant une troisième période ($t_C$) qui est nettement plus courte qu'une quatrième période ($t_D$) pendant laquelle le signal d'alimentation en courant continu est appliqué à ladite sortie.

**2.** Unité d'alimentation électrique selon la revendication 1, **caractérisée en ce que** l'unité de commutation commandée (13) comporte une entrée de commande ($13_s$) qui est en relation fonctionnelle avec la sortie d'une unité de détection d'étincelle (60).

**3.** Unité d' alimentation selon la revendication 1 ou 2, **caractérisée en ce que** la génératrice HF (5) comporte une unité d'alimentation électrique (7) dont la sortie (7a) est en relation fonctionnelle avec un oscillateur HF (9), l'unité de commutation commandée (13) étant prévue entre la sortie (7a) de l'unité d'alimentation (7) de la génératrice HF (5) et la sortie (5a) de la génératrice (5).

**4.** Unité d'alimentation selon la revendication 2 ou 3, **caractérisée en ce que** l'unité de détection d'étincelle (60) comprend une unité de mesure de potentiel de courant continu dont la sortie est en relation fonctionnelle avec l'entrée d'une unité de détection de valeurs seuils (62) de préférence réglable dont la sortie est elle-même en relation fonctionnelle avec l'entrée de commande (13$_s$).

5. Unité d'alimentation selon l'une des revendications 1 à 4, **caractérisée en ce que** la première période (t$_A$) est de 40 $\mu$s au maximum, de préférence de 30 $\mu$s au maximum.

6. Unité d'alimentation selon l'une des revendications 2 à 5, **caractérisée en ce qu'**une période qui s'écoule à partir de l'apparition d'un signal déclenchant l'unité de détection d'étincelle (60) jusqu'au déclenchement de la première période (t$_A$) est de 50 $\mu$s au maximum, de préférence de 30 $\mu$s au maximum.

7. Unité d'alimentation selon l'une des revendications 2 à 6, **caractérisée en ce que** l'unité de commutation commandée est conçue à la manière d'une unité monostable qui arrête pour une période (t$_A$) de préférence réglable le signal d'alimentation HF qui est déclenché par un signal de détection à la sortie de l'unité de détection d'étincelle (60).

8. Unité d'alimentation selon l'une des revendications 1 à 6, **caractérisée en ce que** l'entrée de commande de l'unité de commutation commandée est en relation fonctionnelle avec une unité d'horloge à oscillation libre (15) qui arrête de manière répétée le signal d'alimentation HF pendant la première période (t$_A$).

9. Unité d'alimentation selon la revendication 2, **caractérisée en ce que** l'entrée de commande (33$_s$) de l'autre unité de commutation (33) de la génératrice à courant continu (25) est en relation fonctionnelle avec la sortie de l'unité de détection d'étincelle (60).

10. Unité d'alimentation selon la revendication 9, **caractérisée en ce que** l'entrée de commande (13$_s$) de l'unité de commutation commandée (13) de la génératrice HF (5) et l'entrée de commande (33$_s$) de l'autre unité de commutation commandée (33) de la génératrice à courant continu (25) sont en relation fonctionnelle par l'intermédiaire d'une unité d'horloge (15, 43, 35) de sorte que la troisième période (t$_C$) commence avant la première (t$_A$) et se termine avant ou après, de préférence avant la première (t$_A$) .

11. Installation de pulvérisation cathodique comportant une chambre à vide (1) et un espace de décharge de plasma (PL), **caractérisée en ce que** l'espace de décharge de plasma (PL) est relié à une unité d'alimentation (3) pour l'alimentation électrique de l'espace de décharge de plasma selon l'une des revendications 1 à 10.

12. Installation de pulvérisation cathodique selon la revendication 11, **caractérisé en ce qu'**elle est conçue comme une installation d'application de revêtement par pulvérisation cathodique et l'une des électrodes de décharge de plasma comprend une cible en oxyde métallique, de préférence une cible ITO.

13. Installation de pulvérisation cathodique selon la revendication 11 ou 12, **caractérisée en ce que** l'une des électrodes de décharge de plasma est une électrode de magnétron.

14. Procédé pour réduire la formation d'étincelles lors de la pulvérisation cathodique, selon lequel la décharge de plasma (PL) est alimentée au moins en partie à l'aide d'énergie HF, étant précisé qu'on interrompt temporairement (t$_A$) l'alimentation HF de la décharge de plasma, **caractérisé en ce qu'**on alimente en supplément la décharge de plasma à l'aide d'une alimentation en courant continu (25) et on arrête aussi temporairement l'alimentation en courant continu.

15. Procédé selon la revendication 14, **caractérisé en ce qu'**on arrête l'alimentation en courant continu avant l'alimentation HF.

16. Procédé selon la revendication 14 ou 15, **caractérisé en ce qu'**on arrête temporairement (t$_A$) l'alimentation HF en raison de la détection (60) de la formation d'une étincelle dans la chambre (1).

17. Procédé selon l'une des revendications 14 à 16, **caractérisé en ce qu'**on arrête l'alimentation HF sans arrêter l'alimentation électrique (7) d'une génératrice HF (5) pour produire l'alimentation HF.

18. Procédé selon la revendication 16 ou 17, **caractérisé en ce qu'**on détecte la formation d'une étincelle en mesurant un potentiel de courant continu au niveau de la décharge de plasma.

19. Procédé selon l'une des revendications 14 à 18, **caractérisé en ce qu'**on arrête l'alimentation HF pendant 40 $\mu$s au maximum, de préférence pendant 30 $\mu$s au maximum.

20. Procédé selon l'une des revendications 16 à 19, **caractérisé en ce qu'**à partir de la détection de la formation d'une étincelle, on arrête l'alimentation HF au bout de 50 $\mu$s au maximum, de préférence au bout de 30 $\mu$s au maximum.

21. Procédé selon l'une des revendications 14 à 20, **caractérisé en ce qu'**on arrête de manière répétée l'alimentation HF, de préférence périodiquement.

22. Procédé selon la revendication 14, **caractérisé en ce qu'**on arrête l'alimentation en courant continu en raison de la détection de la formation d'une étincelle.

23. Procédé selon la revendication 14, **caractérisé en ce qu'**on rétablit l'alimentation en courant continu avant ou après l'alimentation haute fréquence, de préférence avant.

24. Procédé pour fabriquer des éléments à l'aide d'un procédé de pulvérisation cathodique, selon lequel l'alimentation de la décharge de plasma de pulvérisation cathodique comporte un composant HF et selon lequel on arrête temporairement le composant d'alimentation HF, **caractérisé en ce qu'**on alimente en supplément la décharge de plasma à l'aide d'une alimentation en courant continu (25) et on arrête temporairement ladite alimentation en courant continu.

FIG.1

FIG.2

FIG.3

FIG.4

FIG.5